(19) Europäisches Patentamt
European Patent Office
Office européen des brevets

(11) EP 4 768 647 A1

(12) EUROPEAN PATENT APPLICATION
published in accordance with Art. 153(4) EPC

(43) Date of publication:
01.07.2026 Bulletin 2026/27

(21) Application number: 24856282.9

(22) Date of filing: 06.08.2024

(51) International Patent Classification (IPC):
C30B 29/06 (2006.01)        C30B 25/20 (2006.01)
C30B 33/02 (2006.01)        H01L 21/02 (2006.01)
H01L 21/20 (2006.01)        H01L 21/205 (2006.01)
H01L 21/316 (2006.01)       H10D 86/00 (2025.01)

(52) Cooperative Patent Classification (CPC):
C30B 25/20; C30B 29/06; C30B 33/02;
H10P 14/20; H10P 14/29; H10P 36/00; H10P 95/00

(86) International application number:
PCT/JP2024/028001

(87) International publication number:
WO 2025/041591 (27.02.2025 Gazette 2025/09)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 23.08.2023 JP 2023135798

(71) Applicant: Shin-Etsu Handotai Co., Ltd.
Tokyo 100-0004 (JP)

(72) Inventors:
• IKIGAKI Ken
  Annaka-shi, Gunma 379-0196 (JP)
• SUZUKI Atsushi
  Nishishirakawa-gun, Fukushima 961-8061 (JP)

(74) Representative: Schicker, Silvia
Wuesthoff & Wuesthoff
Patentanwälte und Rechtsanwalt PartG mbB
Schweigerstraße 2
81541 München (DE)

(54) **EPITAXIAL WAFER AND PRODUCTION METHOD THEREFOR**

(57) The present invention is an epitaxial wafer including, in this order, a silicon epitaxial film having a carbon concentration of $2\times10^{19}$ atoms/cm$^3$ or more and less than $3\times10^{20}$ atoms/cm$^3$ and containing carbon defects and a dielectric layer on a silicon single crystal substrate having a resistivity of 10 $\Omega$·cm or more and 5000 $\Omega$·cm or less, in which a thickness of the silicon epitaxial film satisfies $6.6 \times 10^{20} \times \exp\{-1.6 \times$ [the thickness of the epitaxial film ($\mu$m)]\} > [the carbon concentration of the epitaxial film (atoms/cm$^3$)]. This provides the silicon epitaxial wafer in which the silicon epitaxial film is formed on a standard-resistivity silicon substrate, the silicon epitaxial wafer having superior capability of reducing harmonics, and excellent processability for use as a substrate for a high-frequency integrated circuit, and further provides the method for manufacturing the same.

[FIG. 1]

**Description**

TECHNICAL FIELD

The present invention relates to an epitaxial wafer and a method for manufacturing the same.

BACKGROUND ART

In recent years, demand for high-capacity communication has been extremely high, and development of equipment for use in fifth and sixth-generation mobile communication systems (generally referred to as 5G and 6G) is accelerating. These items of telecommunication equipment are incorporated integrated circuits, and active devices (such as transistors) and passive devices (such as inductors) that constitute the integrated circuits are required to have high operational stability under 5G and 6G environments. In particular, high-frequency bands (from millimetric-wave to sub-terahertz band) are expected to be used in these high-capacity telecommunication systems; therefore, device designs and material developments that combine excellent high-frequency characteristics with powersaving performance are in social demand.

When turning to materials required for semiconductor integrated circuits, silicon wafers produced by a CZ (Czochralski) method are sometimes employed as substrates for high-frequency integrated circuits. The silicon wafers used in these cases are required to have high substrate resistivity in order to achieve low resistivity losses and excellent high-frequency characteristics.

Furthermore, in applications where more excellent high-frequency characteristics are required, wafers in which trap-rich (Trap-rich) layers are formed, as disclosed in Patent Document 1 and Patent Document 2, are commonly used. This is because it is known that when a high-frequency signal is input into a device formed on a high-resistivity substrate, an inversion layer is formed in the substrate, which leads to a phenomenon in which the resistivity thereof is changed; consequently, the trap-rich layer captures a carrier generated in the inversion layer at a deep level, enabling high substrate resistivity to be maintained. In particular, for the passive device, a wafer is used, in which a polysilicon layer is formed as the trap-rich layer on the high-resistivity substrate. In contrast, an SOI wafer having a trap-rich layer is widely used for active devices. In a structure of such an SOI wafer, the polysilicon layer as the trap-rich layer, an oxide film as a dielectric layer, and a single-crystal silicon layer are stacked in this order on the high-resistivity substrate.

However, the production of the high-resistivity substrate, which is widely used as the substrate for high-frequency integrated circuits, poses a great technical difficulty in controlling the resistivity, resulting in a low yield. Additionally, polysilicon used for the trap-rich layer presents high processing difficulty, leading to productivity degradation. Furthermore, an SOI structure, in which polysilicon is used for the trap-rich layer, has complex production processes and a major cost-related issue. Accordingly, technology development has been required to exhibit excellent high-frequency characteristics and, in particular, reduce harmonics in an epitaxial wafer, in which a silicon epitaxial film is formed on a silicon single crystal substrate (hereinafter, also simply referred to as "silicon substrate"), without using the high-resistivity substrate.

Moreover, Patent Document 3 and Patent Document 4 disclose wafers having epitaxial films doped with carbon formed on a silicon substrate. However, the wafers disclosed in Patent Document 3 and Patent Document 4 are essentially epitaxial wafers composed of a silicon substrate, an epitaxial film doped with carbon, and a silicon epitaxial film, primarily intended for use in imaging devices, and no disclosure is provided regarding heat treatment to these wafers after epitaxial film formation, and thus, no trap-rich layer is formed within the epitaxial film.

Furthermore, Patent Document 5 discloses an epitaxial wafer subjected to heat treatment on a wafer where an epitaxial film doped with carbon has been formed on a silicon substrate. However, no reference is made to applications for wafers for high-frequency devices or epitaxial wafers having trap-rich layers formed therein.

In Patent Document 5, a silicon epitaxial film having a high concentration of carbon is developed with the intention of utilizing it as a gettering layer, and the purpose of the heat treatment is to drive gettering. Consequently, heat treatment conditions of about 30 minutes within a range of 450 to 750°C are disclosed. Although the heat treatment at 800 to 1000°C is also disclosed to drive the gettering in a shorter time, it is inferred that the heat treatment time is 30 minutes or less. However, under such conditions, it is difficult to obtain stable high-frequency characteristics.

From the foregoing, the wafers disclosed in Patent Document 3, Patent Document 4, and Patent Document 5 have difficulties in being employed as wafers for a high-frequency device.

CITATION LIST

PATENT LITERATURE

Patent Document 1: JP 2015-503853 A
Patent Document 2: JP 2019-129195 A
Patent Document 3: JP 2009-164590 A
Patent Document 4: JP 2009-200231 A
Patent Document 5: JP 2006-216934 A

## SUMMARY OF INVENTION

### TECHNICAL PROBLEM

As described above, as a substrate for a high-frequency integrated circuit, an epitaxial wafer capable of reducing harmonics without using a high resistivity substrate and having a trap-rich layer has been desired. In earnest pursuit of developing a material capable of meeting such requirements, the present inventors found that an epitaxial wafer in which a silicon epitaxial film containing a high concentration of carbon is formed on a standard-resistivity substrate and subjected to heat treatment is promising. This can provide the substrate for the high-frequency integrated circuit that can be produced with fewer steps and easier processing.

However, even these substrates do not reach the levels of harmonics reduction capability exhibited by the conventional epitaxial wafer using a polysilicon layer as a trap-rich layer. Thus, the development of an epitaxial wafer exhibiting superior high-frequency characteristics has been an urgent priority.

The present invention has been made in view of the above-described problem. An object of the present invention is to provide a silicon epitaxial wafer and a method for manufacturing the same, in which the silicon epitaxial wafer, employed as a substrate for a high-frequency integrated circuit and having the silicon epitaxial film formed on a standard-resistive silicon substrate, exhibits excellent capability of reducing harmonics, and allows easy processing.

### SOLUTION TO PROBLEM

To achieve the object, the present invention provides an epitaxial wafer comprising, in this order, a silicon epitaxial film having a carbon concentration of $2 \times 10^{19}$ atoms/cm$^3$ or more and less than $3 \times 10^{20}$ atoms/cm$^3$ and containing carbon defects and a dielectric layer on a silicon single crystal substrate having a resistivity of 10 $\Omega \cdot$cm or more and 5000 $\Omega \cdot$cm or less, wherein

a thickness of the silicon epitaxial film satisfies $6.6 \times 10^{20} \times \exp\{-1.6 \times$ [the thickness of the epitaxial film ($\mu$m)]\} > [the carbon concentration of the epitaxial film (atoms/cm$^3$)].

With such an epitaxial wafer, by virtue of the dielectric layer on the silicon epitaxial film having the above carbon concentration, an insulating property of the substrate is improved, and a film quality of the epitaxial wafer is also stabilized at a high level. Moreover, minute carbon defects can be contained within the silicon epitaxial film, and this effect makes the wafer have excellent high-frequency characteristics.

In this case, the epitaxial wafer can be a wafer for a high-frequency device.

In the epitaxial wafer, by virtue of the dielectric layer on the silicon epitaxial film having the above carbon concentration, the insulating property of the substrate is improved, and the film quality of the epitaxial wafer is stabilized at a high level. Furthermore, the minute carbon defects can be contained in the silicon epitaxial film, and this effect makes the wafer have excellent high-frequency characteristics, and thus, this wafer is suitable for the wafer for a high-frequency device.

In this case, the carbon defects can have a size of 10 nm or less, and a density of $1 \times 10^{10}$ cm$^{-2}$ or more in the epitaxial film.

With the epitaxial wafer provided with such carbon defects, by virtue of the effect of the silicon epitaxial film containing the minute carbon defects at high density, the wafer has excellent high-frequency characteristics.

Moreover, the present invention provides a method for manufacturing an epitaxial wafer, the method comprising the steps of:

providing a silicon single crystal substrate having a resistivity of 10 $\Omega \cdot$cm or more and 5000 $\Omega \cdot$cm or less;
vapor-phase growing a silicon epitaxial film doped with carbon having a carbon concentration of $2 \times 10^{19}$ atoms/cm$^3$ or more and less than $3 \times 10^{20}$ atoms/cm$^3$ on the silicon single crystal substrate, under reduced pressure;
forming a dielectric layer on the silicon epitaxial film; and
forming carbon defects in the silicon epitaxial film by subjecting the silicon single crystal substrate on which the dielectric layer has been formed to heat treatment at a heat treatment temperature of 900°C or more and 1100°C or less for a heat treatment time of 3 hours or more and 36 hours or less, wherein
the silicon epitaxial film is formed in the step of vapor-phase growing a silicon epitaxial film, in which the silicon epitaxial film has a thickness that satisfies $6.6 \times 10^{20} \times \exp\{-1.6 \times$ [the thickness of the epitaxial film ($\mu$m)]\} > [the carbon

concentration of the epitaxial film (atoms/cm$^3$)].

With such a method for manufacturing an epitaxial wafer, which includes vapor-phase growing a silicon epitaxial film, forming a dielectric layer, and forming minute carbon defects at high density in the silicon epitaxial film by subsequent heat treatment, the epitaxial wafer exhibiting the excellent high-frequency characteristics described above can be easily manufactured.

In this case, the epitaxial wafer manufactured by the method for manufacturing an epitaxial wafer described above can be employed as a wafer for a high-frequency device.

In the epitaxial wafer, by virtue of the dielectric layer on the silicon epitaxial film having the above carbon concentration, the insulating property of the substrate is improved, and the film quality of the epitaxial wafer is stabilized at a high level. Furthermore, the minute carbon defects can be formed at high density in the silicon epitaxial film, and this effect makes the wafer have excellent high-frequency characteristics, and thus, this wafer is suitable for the wafer for a high-frequency device.

In this case, the carbon defects can have a size of 10 nm or less, and a density of $1 \times 10^{10}$ cm$^{-2}$ or more in the epitaxial film.

The epitaxial wafer, provided with the silicon epitaxial film containing such minute carbon defects at high density and having superior high-frequency characteristics, can be manufactured.

ADVANTAGEOUS EFFECTS OF INVENTION

As described above, according to the inventive silicon epitaxial wafer, this wafer is not required to employ a high-resistivity substrate, and by virtue of an effect of the silicon epitaxial film containing the minute carbon defects at high density and the dielectric layer provided on the epitaxial film, the silicon epitaxial wafer exhibits superior harmonics reduction capability compared with a conventional epitaxial wafer in which a polysilicon layer is formed as a trap-rich layer on the high-resistivity substrate, and is therefore suitable for the wafer for a high-frequency device. Moreover, according to the inventive method for manufacturing an epitaxial wafer, the epitaxial wafer exhibiting the excellent capability of reducing harmonics described above can be easily manufactured.

BRIEF DESCRIPTION OF DRAWINGS

[FIG. 1] is a schematic view illustrating an epitaxial wafer according to the present invention.

[FIG. 2] is a flow diagram showing an example of a method for manufacturing an epitaxial wafer according to the present invention.

[FIG. 3] is a graph showing the conditions of carbon concentrations and film thicknesses of silicon epitaxial films, where Void defect regions are formed in the vicinity of an interface between a silicon epitaxial film and a silicon substrate, in an epitaxial wafer according to the present invention.

[FIG. 4] is a plot showing variations in the second harmonics and the third harmonics characteristics of an epitaxial wafer in Experimental Example 2, when heat treatment is performed on the epitaxial wafer with varying heat treatment times.

[FIG. 5] is a graph, for epitaxial wafers in Example 1 and Comparative Examples 1 and 2, showing a relation between the second harmonics characteristics and carbon concentrations, and a relation between the third harmonics characteristics and carbon concentrations.

DESCRIPTION OF EMBODIMENTS

Hereinafter, the present invention will be described in detail. However, the present invention is not limited thereto.

As described above, due to demands for miniaturization, power saving, and cost reduction of telecommunication equipment, an inexpensive epitaxial wafer capable of further improving high-frequency characteristics, particularly reducing harmonics, has been desired.

The present inventors, as a result of earnest studies on the above problem, have found that an epitaxial wafer including, in this order, a silicon epitaxial film having a carbon concentration of $2 \times 10^{19}$ atoms/cm$^3$ or more and less than $3 \times 10^{20}$ atoms/cm$^3$ and containing carbon defects and a dielectric layer on a silicon single crystal substrate having a resistivity of 10 $\Omega \cdot$cm or more and 5000 $\Omega \cdot$cm or less, in which a thickness of the silicon epitaxial film satisfies $6.6 \times 10^{20} \times \exp\{-1.6 \times$ [the thickness of the epitaxial film ($\mu$m)]$\} >$ [the carbon concentration of the epitaxial film (atoms/cm$^3$)] can exhibit excellent capability of reducing harmonics by virtue of the effect of the dielectric layer provided on the silicon epitaxial film containing the minute carbon defects. This finding led to the completion of the present invention.

The present inventors have also found that the above epitaxial wafer, which exhibits excellent capability of reducing harmonics, can be easily manufactured by a method for manufacturing an epitaxial wafer, the method including the steps of:

providing a silicon single crystal substrate having a resistivity of 10 $\Omega$·cm or more and 5000 $\Omega$·cm or less;
vapor-phase growing a silicon epitaxial film doped with carbon having a carbon concentration of $2 \times 10^{19}$ atoms/cm$^3$ or more and less than $3 \times 10^{20}$ atoms/cm$^3$ on the silicon single crystal substrate, under reduced pressure;
forming a dielectric layer on the silicon epitaxial film; and
forming carbon defects in the silicon epitaxial film by subjecting the silicon single crystal substrate on which the dielectric layer has been formed to heat treatment at a heat treatment temperature of 900°C or more and 1100°C or less for a heat treatment time of 3 hours or more and 36 hours or less, wherein
the silicon epitaxial film is formed in the step of vapor-phase growing a silicon epitaxial film, in which the silicon epitaxial film has a thickness that satisfies $6.6 \times 10^{20} \times \exp\{-1.6 \times$ [the thickness of the epitaxial film ($\mu$m)]$\}$ > [the carbon concentration of the epitaxial film (atoms/cm$^3$)]. This finding led to the completion of the present invention.

[Inventive Epitaxial Wafer]

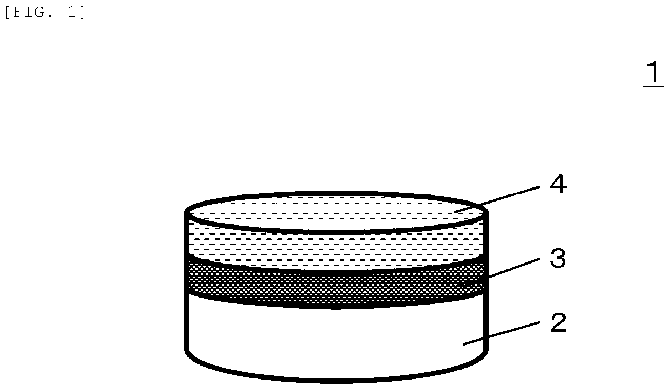

Hereinafter, the inventive epitaxial wafer will be described with reference to FIG. 1. As shown in FIG. 1, the inventive epitaxial wafer 1 is provided with a silicon epitaxial film 3 containing carbon defects and a dielectric layer 4 in this order, on a silicon substrate 2.

The silicon substrate 2 has a resistivity of 10 $\Omega$·cm or more and 5000 $\Omega$·cm or less. The silicon substrate 2, having a resistivity in this range, is a substrate that can be employed for a high-frequency device. In particular, it is more preferable that the resistivity described above is approximately 1000 to 5000 $\Omega$·cm, in which high-frequency characteristics are excellent, and the resistivity is controllable during the production of a single crystal.

The silicon epitaxial film 3 contains carbon at a concentration of $2 \times 10^{19}$ atoms/cm$^3$ or more and less than $3 \times 10^{20}$ atoms/cm$^3$, which significantly exceeds a typical solid solubility limit of carbon of $3 \times 10^{17}$ atoms/cm$^3$ (maximum solid solubility limit of carbon at a melting point of silicon) and contains the minute carbon defects. Moreover, the Void defects are not contained therein.

It is preferable that minute carbon defects contained in the silicon epitaxial film 3 have a size of approximately 10 nm or less, and a density of approximately $1 \times 10^{10}$ cm$^{-2}$ or more in the silicon epitaxial film 3 (when the carbon concentration of the silicon epitaxial film 3 doped with carbon is lower than that in the present invention, the carbon defects having a size of approximately 25 nm or more are included at low density). The lower limit of the size and the upper limit of the density are not particularly limited, but the lower limit of the size can be 3 nm or more, and the upper limit of the density can be $1 \times 10^{12}$ cm$^{-2}$ or less, respectively. Note that the size of the carbon defects is defined as a measured value of the longest portion of the defects, which is detected in a cross-sectional TEM. This also applies to the method for manufacturing an epitaxial wafer, as described later.

The thickness and the carbon concentration of the silicon epitaxial film 3 satisfy a relation of $6.6 \times 10^{20} \times \exp\{-1.6 \times$ [the thickness of the epitaxial film ($\mu$m)]$\}$ > [the carbon concentration of the epitaxial film (atoms/cm$^3$)] such that the silicon epitaxial film 3 does not contain the Void defects.

The dielectric layer 4 on a surface of the silicon epitaxial film 3 functions as an insulating film, enhances the insulating property of the substrate, and also prevents roughening of the silicon epitaxial film 3 by heat treatment, thereby providing a stabilizing effect on the film quality at a high level.

Furthermore, by subjecting the silicon substrate to heat treatment after forming the dielectric layer 4, the silicon epitaxial film 3 contains the minute carbon defects at high density. Because of the effect of minute carbon defects, the epitaxial wafer exhibits excellent high-frequency characteristics. This is considered to be because the heat treatment forms the minute carbon defects in the silicon epitaxial film, thereby forming deep levels, enhancing the function thereof as a trap-rich layer, and consequently, inhibiting the formation of an inversion layer.

Such an epitaxial wafer has advantage of the minute carbon defects in the silicon epitaxial film, has excellent harmonic characteristics due to the high insulating property of the substrate, and is suitable for a wafer for a high-frequency device or a substrate for an active device.

The lower limit of the carbon concentration of the silicon epitaxial film 3 is defined as $2.0 \times 10^{19}$ atoms/cm$^3$ or more, the upper limit of that is defined as less than $3 \times 10^{20}$ atoms/cm$^3$. Such carbon concentration significantly exceeds a typical solid solubility limit of carbon, enabling the formation of a high density of minute carbon defects by heat treatment, thereby achieving sufficiently high-frequency characteristics. In contrast, when the carbon concentration is lower than the lower limit, low supersaturation of carbon results in the formation of coarse carbon defects, and reduced defect density, preventing the achievement of sufficient high-frequency characteristics. On the other hand, when the carbon concentration is $2.0 \times 10^{19}$ atoms/cm$^3$ or more, the Void defects are formed by an excess of the film thickness over a predetermined value, leading to the coexistence of the Void defects and the minute carbon defects in the film. This causes improvement in the high-frequency characteristics by heat treatment, but the range of improvement becomes smaller. It is considered that the volume of the Void defects is significantly larger compared with that of the carbon defects, thereby making the effect of the Void defects dominant. Consequently, in order for the epitaxial wafer to exhibit significantly excellent high-frequency characteristics, it is important that the thickness of the silicon epitaxial film 3 be sufficiently thin to prevent the formation of the Void defects. Moreover, when the carbon concentration becomes $3 \times 10^{20}$ atoms/cm$^3$ or more, in addition to the degradation of the film quality of the silicon epitaxial film 3 doped with carbon, productivity of the wafer is also decreased. The upper limit of the carbon concentration depends on the silicon epitaxial film thickness, and the upper limit of the carbon concentration can be determined from the following relational expression, $6.6 \times 10^{20} \times \exp\{-1.6 \times$ [the thickness of the epitaxial film ($\mu$m)]} > [the carbon concentration of the epitaxial film (atoms/cm$^3$)]. In such a concentration, excellent high-frequency characteristics are stably achieved. This also applies to the method for manufacturing an epitaxial wafer described later.

The lower limit and the upper limit of the thickness of the silicon epitaxial film 3 can be, for example, 0.1 $\mu$m or more and 2.5 $\mu$m or less, respectively, considering productivity and cost. When the film thickness is within this range, the epitaxial wafer has sufficient high-frequency characteristics at a lower cost. However, when the silicon epitaxial film has a carbon concentration of $2.0 \times 10^{19}$ atoms/cm$^3$ or more, heat treatment of the silicon epitaxial film tends to form the Void defect region at the interface between the silicon epitaxial film and the silicon substrate. The Void defects are aggregates of vacancies, and therefore, the reduction of the amount of vacancies generated within the film by reducing the thickness of the silicon epitaxial film 3 leads to the suppression of the formation of the Void defects. Consequently, the film thickness is required to be adjusted according to the carbon concentration. Based on the above, a relation between the thickness and the carbon concentration of the silicon epitaxial film 3 is required to satisfy the following expression,

$6.6 \times 10^{20} \times \exp\{-1.6 \times$ [the thickness of the epitaxial film ($\mu$m)]} > [the carbon concentration of the epitaxial film (atoms/cm$^3$)].

(Experimental Example 1)

Experimental results evaluating a relation between carbon concentration and film thickness of an epitaxial film will be described below, in which the silicon epitaxial film is doped with carbon and formed on a silicon substrate, and Void defects are not formed in the epitaxial film.

The present inventors formed silicon epitaxial films on silicon substrates using a reduced-pressure CVD apparatus in which the films contained carbon of $2.0 \times 10^{19}$ atoms/cm$^3$ or more and had varied thicknesses (a sample having a carbon concentration of $2.0 \times 10^{19}$ atoms/cm$^3$ had a thickness of 1 $\mu$m, 1.5 $\mu$m, 2 $\mu$m, 3$\mu$m, and 5.5um; a sample having a carbon concentration of $1.0 \times 10^{20}$ atoms/cm$^3$ had a thickness of 1 $\mu$m, 2 $\mu$m, and 3 $\mu$m; a sample having a carbon concentration of $3.0 \times 10^{20}$ atoms/cm$^3$ and a sample having a carbon concentration of $1.0 \times 10^{21}$ atoms/cm$^3$ had a thickness of 1 $\mu$m). An adjustment of the respective carbon concentration and thickness of the silicon epitaxial film was performed by varying the introduced amount of source gas and treatment time in a reduced CVD reactor.

In order to evaluate the presence or absence of the Void defect region in these epitaxial wafers, the obtained epitaxial wafers were subjected to heat treatment at 1000°C for 36 hours under an oxygen atmosphere. After heat treatment, a plan-view TEM observation was performed using thin samples (thickness of approximately 500 nm) that included an interface between the silicon epitaxial film and the silicon substrate of each epitaxial wafer.

As a result of Experimental Example 1, it was found that the Void defect region was formed in the vicinity of the interface between the silicon epitaxial film and the silicon substrate under the following conditions:

for the sample having a carbon concentration of $2.0 \times 10^{19}$ atoms/cm$^3$, when the film thickness was 3 $\mu$m or more;
for the sample having a carbon concentration of $1.0 \times 10^{20}$ atoms/cm$^3$, when the film thickness was 2 $\mu$m or more; and
for the sample having a carbon concentration of $3.0 \times 10^{20}$ atoms/cm$^3$ or more, when the film thickness was 1 $\mu$m.

According to the above result, the present inventors concluded that conditions under which the Void defects were formed in the silicon epitaxial film by heat treatment varied depending on both the carbon concentration contained in the silicon epitaxial film and the thickness of the silicon epitaxial film.

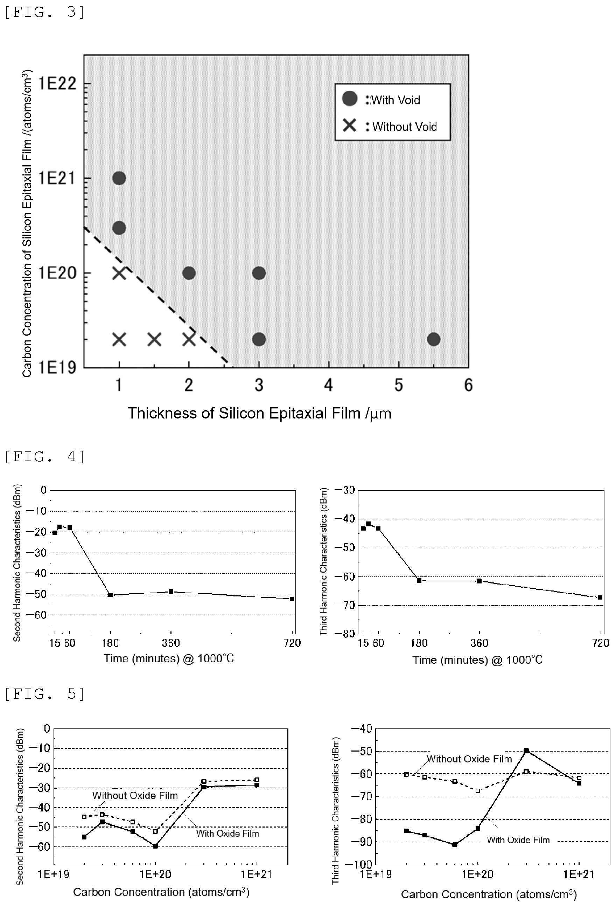

FIG. 3 shows a result in which the presence or the absence of the Void defect region shown in Experimental Example 1 was arranged by the carbon concentration contained in the silicon epitaxial film and the thickness of the silicon epitaxial film.

FIG. 3 is a graph showing the conditions of the carbon concentrations of the silicon epitaxial film and the thickness of the silicon epitaxial film, in which Void defect regions are formed in the vicinity of the interface between the silicon epitaxial film and the silicon substrate in the inventive epitaxial wafer. At this time, a region, where the Void defect region is formed at the interface between the silicon epitaxial film and the silicon substrate after heat treatment, is indicated by a dashed line and a shaded area in the figure. That is, a white area in the figure is a region where the Void defect region is not formed in the silicon epitaxial film. This can be a range, in the relation between the carbon concentration contained in the silicon epitaxial film and the film thickness, that satisfies the following expression,

$6.6 \times 10^{20} \times \exp\{-1.6 \times$ [the thickness of the epitaxial film ($\mu$m)]$\} >$ [the carbon concentration of the epitaxial film (atoms/cm$^3$)].

According to such an inventive silicon epitaxial wafer, it is not required to employ a high-resistivity substrate, and by virtue of an effect of the silicon epitaxial film containing the minute carbon defects at high density and the dielectric layer provided on the epitaxial film, this silicon epitaxial wafer exhibits superior harmonics reduction capability compared with a conventional epitaxial wafer in which a polysilicon layer is formed as a trap-rich layer on a high-resistivity substrate, and is therefore suitable for a wafer for a high-frequency device.

[Method for Manufacturing Epitaxial Wafer]

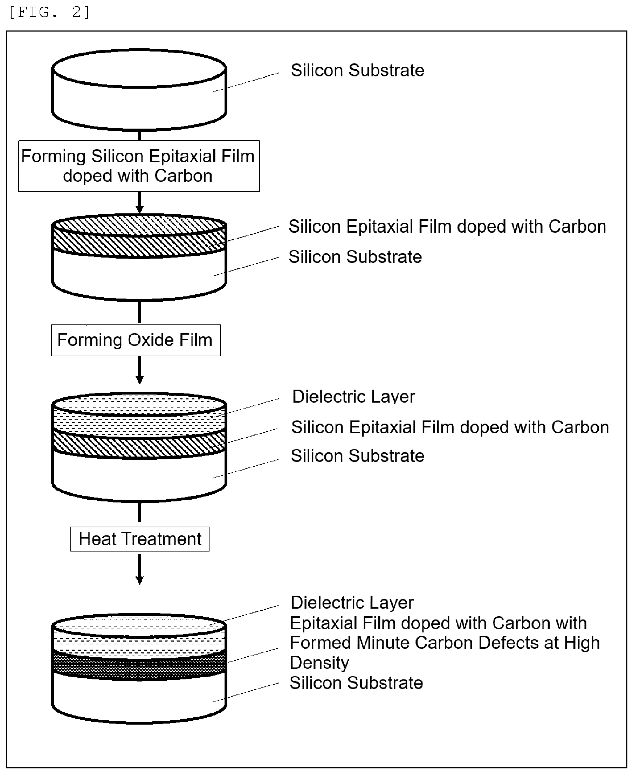

FIG. 2 shows an example of the inventive method for manufacturing an epitaxial wafer. This is a method for manufacturing an epitaxial wafer having a dielectric layer formed on the silicon epitaxial film with carbon defects formed therein at high density that serves as a trap-rich layer.

(Step of Providing Silicon Single Crystal Substrate)

First, a silicon substrate having a resistivity of 10 to 5000 $\Omega\cdot$cm is provided.

(Step of Vapor-phase Growing Silicon Epitaxial Film doped with Carbon)

Next, by supplying a gas containing silicon atoms and carbon atoms onto the silicon substrate under reduced pressure, the silicon epitaxial film doped with carbon (hereinafter, also simply referred to as "epitaxial film") is vapor-phase grown on a surface of the silicon substrate, in which the epitaxial film has a carbon concentration of $2\times10^{19}$ atoms/cm$^3$ or more and less than $3\times10^{20}$ atoms/cm$^3$ and a relation between the thickness and the carbon concentration of the epitaxial film satisfies the following expression,

$6.6 \times 10^{20} \times \exp\{-1.6 \times$ [the thickness of the epitaxial film ($\mu$m)]$\} >$ [the carbon concentration of the epitaxial film (atoms/cm$^3$)].

Subsequently, the dielectric layer is formed on the epitaxial film. Then, the epitaxial wafer having the dielectric layer formed on the epitaxial film is subjected to heat treatment; accordingly, the minute carbon defects can be formed at high density in the epitaxial film.

By vapor-phase growing the epitaxial film under reduced pressure, it is possible to lower the concentration of impurities other than carbon doped into the epitaxial film. A pressure for forming the epitaxial film may only be reduced pressure, and is not particularly required to be limited to any pressures, but it is preferable to form the film at approximately 10 Torr (about 1.3 kPa), for example, at 5 Torr (about 0.67 kPa) or more and 20 Torr (about 2.7 kPa) or less.

In the vapor-phase growth of the epitaxial film, the carbon doping is performed using the gas (raw material gas) containing the silicon atoms and the carbon atoms, as described above. As the raw material gas, it is preferable to contain at least one of monomethylsilane gas and trimethylsilane gas. By using these gases, it is possible to easily and favorably perform carbon-doping of the silicon epitaxial film. Moreover, as a carrier gas during the supply of the raw material gas, an atmosphere for vapor-phase growth may contain hydrogen, argon, or other gases.

Regarding the epitaxial film under reduced pressure, the epitaxial film can be favorably formed by vapor-phase growth at 600 to 1000°C.

Moreover, the pressure, temperature, time, raw material gas concentration, and the like for the vapor-phase growth are preferably set appropriately such that the epitaxial film thickness to be formed has an intended thickness. The thickness of the epitaxial film can be, for example, 0.1 $\mu$m or more and 2.5 $\mu$m or less, but not limited thereto, as long as the thickness range satisfies the following expression,

$6.6 \times 10^{20} \times \exp\{-1.6 \times$ [the thickness of the epitaxial film ($\mu$m)]$\} >$ [the carbon concentration of the epitaxial film (atoms/cm$^3$)].

When the carbon concentration and the film thickness of the epitaxial film have such a relation, the Void defects are not formed in the epitaxial film.

(Step of Forming Dielectric Layer)

A method for forming a dielectric layer onto the epitaxial film, or a material composing the layer, is not particularly limited, and a typical silicon oxide film formed using a pyrogenic oxidation method can be employed. Such a method can efficiently form the dielectric layer to a desired thickness.

The thickness of the dielectric layer is also not particularly limited, but, for example, can be 10 nm or more and 5 $\mu$m or less. The epitaxial wafer provided with such a dielectric layer has sufficient high-frequency characteristics at a lower cost.

The temperature of forming the dielectric layer can be, for example, a high-temperature process from 800°C to 1200°C with a heat treatment furnace capable of performing pyrogenic oxidation as a general method for forming a thermal oxide film. In this case, when a high-temperature heat treatment (for example, at a heat treatment temperature of 1000°C for an equivalent of 3 hours or more) is performed to sufficiently form the minute carbon defects within the epitaxial film in the forming process of the dielectric layer formed on the epitaxial film, the heat treatment after the formation of the dielectric layer can be omitted.

(Step of Forming Carbon Defects)

A method of heat treatment of the epitaxial wafer in which the dielectric layer has been formed on the epitaxial film is not particularly limited and can be, for example, employed using a typical heat treatment furnace for a silicon wafer or the heat treatment furnace used for growing the dielectric layer.

In the heat treatment, the lower limit of the heat treatment temperature is set to 900°C or more, and the upper limit of the heat treatment temperature is set to 1100°C or less. In this way, the minute carbon defects can be formed at high density using a typical heat treatment furnace, and the effect of heavy metal diffusion can be suppressed, thereby improving manufacturing efficiency.

Moreover, the heat treatment time is set to 3 hours or more and 36 hours or less. Accordingly, the epitaxial wafer has sufficient minute carbon defects formed therein, improved quality, and is excellent in terms of manufacturing efficiency.

Here, a result of study on the heat treatment time during the heat treatment will be described in the following Experimental Example 2.

(Experimental Example 2)

The heat treatment time when forming minute carbon defects at high density was determined through the following experiments.

In order to perform a basic research on heat treatment time required for manufacturing an epitaxial wafer exhibiting excellent harmonic characteristics, epitaxial wafers having a carbon concentration of $1.0 \times 10^{20}$ atoms/cm$^3$ during the film formation were subjected to heat treatment at 1000°C with a heat treatment time varied in a range from 15 minutes to 12 hours under an oxygen atmosphere. Thereafter, in order to investigate high-frequency characteristics of these epitaxial wafers, second-harmonic characteristics and third-harmonic characteristics were measured.

The measurements of the high-frequency characteristics of the epitaxial wafers are performed as follows.

Measurement of the harmonic characteristics [second harmonic characteristics (2HD) and third harmonic characteristics (3HD)] includes: first, forming Co-planar Waveguide (CPW) made of metal (e.g., aluminum) on a dielectric layer (e.g., oxide film); grounding probes to both ends of metal electrodes; thereafter, inputting a high-frequency signal from one end of the electrodes; and measuring the second harmonics and the third harmonics output from the other end (e.g., input signal frequency: 1 GHz, input power: 15 dBm).

Specifically, aluminum electrodes having a line length of 2200 $\mu$m were formed on the silicon epitaxial film subjected to heat treatment within the above-described range of heat treatment time, and the second harmonic characteristics and the third harmonic characteristics were measured. FIG. 4 shows measurement results. As shown in FIG. 4, when the input signal frequency was set to 1 GHz for the samples in which the heat treatment time was 3 hours or more, the second harmonic characteristics were all approximately -50 dBm, and the third harmonic characteristics were all -60 dBm or less.

These results indicate that, in order to manufacture an epitaxial wafer exhibiting excellent harmonic characteristics by forming the minute carbon defects at high density, it is required to perform heat treatment at 1000°C for at least 3 hours or more. Accordingly, the heat treatment time is set to 3 hours or more and 36 hours or less. Note that regarding the upper limit of the time, the effect of forming the carbon defects did not change even when treating for an excessively long time; accordingly, the time was set to 36 hours or less, in consideration of productivity. Thus, an epitaxial wafer with sufficient minute carbon defects, improved quality, and excellent productivity is obtained.

Based on the above, by directly placing the epitaxial wafer into a heat treatment furnace in which the temperature in the furnace was raised to approximately 1000°C, and subjecting the wafer to heat treatment for about 3 to 36 hours, the minute carbon defects are formed at high density in the epitaxial film that has been formed by vapor-phase growth under reduced pressure. In this case, a gas type used during heat treatment is not particularly limited, and may be, for example, oxygen gas or an inert gas such as argon or nitrogen.

In this way, the inventive epitaxial wafer can be manufactured. As a result of the dielectric layer on the epitaxial film functioning as an insulating film, the wafer exhibits excellent high-frequency characteristics. Accordingly, the inventive epitaxial wafer is suitable as a wafer for a high-frequency device.

According to the inventive method for manufacturing a silicon epitaxial wafer, the epitaxial wafer, in which the minute carbon defects are formed at high density in the epitaxial film, can be easily manufactured without employing a high-resistivity substrate. The manufactured epitaxial wafer has superior harmonic reduction capability compared with a conventional epitaxial wafer in which a polysilicon layer is formed as a trap-rich layer on a high-resistivity substrate due to the effect of the epitaxial film and the dielectric layer formed on this film. As a result, the epitaxial wafer is suitable as a wafer for a high-frequency device.

[High-Frequency Characteristics]

High-frequency characteristics of the inventive epitaxial wafer will be described.

The inventive epitaxial wafer has the minute carbon defects formed at high density in the silicon epitaxial film doped with carbon on the silicon substrate by heat treatment. Accordingly, the trap density of the trap-rich layer is increased compared with that before the heat treatment, resulting in improved carrier trapping capability. Consequently, even when the silicon substrate is not of high resistivity, the inventive epitaxial wafer can obtain superior high-frequency characteristics compared with those of a conventional epitaxial wafer in which a polysilicon layer is formed as a trap-rich layer on a high-resistivity substrate. Furthermore, by virtue of the dielectric layer on the silicon epitaxial film doped with carbon, the insulating property of the substrate is improved, and the film quality is stabilized. Thus, superior high-frequency characteristics can be obtained.

In this way, the inventive epitaxial wafer can improve the second harmonic characteristics and the third harmonic characteristics, and thus, is suitable for the wafer for a high-frequency device.

EXAMPLES

Hereinafter, the present invention will be more specifically described showing Example and Comparative Examples. However, the present invention is not limited thereto.

(Example 1)

In accordance with FIG. 2, an epitaxial wafer in the present invention was manufactured. A silicon epitaxial film doped with carbon (carbon concentration: $2.0 \times 10^{19}$ to $1.0 \times 10^{20}$ atoms/cm$^3$, film thickness: 1 $\mu$m) was formed on a silicon substrate having a diameter of 300 mm (P-type, resistivity of 10 $\Omega \cdot$cm) using monomethylsilane as carbon source gas, in which the silicon substrate was obtained by slicing an ingot produced by a Czochralski method using a reduced pressure CVD apparatus. When the carbon concentration is within this range, Void defects are not formed when the film thickness is 0.1 to 1.1 $\mu$m. After film formation, the obtained wafer was subjected to heat treatment at 1000°C for 2 hours using a pyrogenic oxidation method, thereby forming silicon oxide having a thickness of 400 nm. The epitaxial wafer in which silicon oxide had been formed was subjected to heat treatment in an oxidizing atmosphere at 1000°C for 10 hours, thereby forming the minute carbon defects at high density in the silicon epitaxial film.

The carbon concentrations in the silicon epitaxial film doped with carbon were set to the following four values:

(1) $2.0 \times 10^{19}$ atoms/cm$^3$,
(2) $3.0 \times 10^{19}$ atoms/cm$^3$,
(3) $6.0 \times 10^{19}$ atoms/cm$^3$,
(4) $1.0 \times 10^{20}$ atoms/cm$^3$.

In order to investigate high-frequency characteristics of the epitaxial wafer manufactured in Example 1, second harmonic characteristics and third harmonic characteristics were measured. On a surface of the manufactured epitaxial wafer, aluminum electrodes having a line length of 2200 $\mu$m were formed on a surface of the dielectric layer (silicon oxide, 400 nm) formed on a surface of the silicon epitaxial film (carbon concentration: (1) to (4), film thickness: 1 $\mu$m), in which the minute carbon defects were formed at high density. Thereafter, the high-frequency characteristics of the epitaxial wafer were measured.

FIG. 5 shows the results of the above-described measurement. As shown in FIG. 5, when frequency of input signal was set to 1 GHz, the second harmonic characteristics for the cases in which the carbon concentrations of the silicon epitaxial films were (1) to (4), were (1) -55.0 dBm, (2) -47.3 dBm, (3) -52.4 dBm, and (4) -59.5 dBm, respectively.

Moreover, the third harmonic characteristics were (1) -85.2 dBm, (2) -87.1 dBm, (3) -91.2 dBm, and (4) - 84.1 dBm, respectively. These results indicate that the epitaxial wafer in Example 1 is capable of significantly reducing the harmonics.

(Comparative Example 1)

An epitaxial wafer was manufactured in the same way as in an epitaxial wafer in Example 1, except that a dielectric layer was not formed after forming a silicon epitaxial layer doped with carbon. Specifically, the epitaxial wafer manufactured in the same way as in Example 1 was subjected to heat treatment in an oxidizing atmosphere at 1000°C for 12 hours, thereby forming the minute carbon defects at high density in the silicon epitaxial film. This wafer was defined as the epitaxial wafer in Comparative Example 1.

In the same way as in Example 1, second harmonic characteristics and third harmonic characteristics of the epitaxial wafer in Comparative Example 1 were measured, and FIG. 5 shows the results thereof. In this case, an oxide film formed on the surface of the wafer by heat treatment in an oxidizing atmosphere was removed by hydrofluoric acid (hydrofluoric acid), and aluminum electrodes with a line length of 2200 $\mu$m were then formed on the surface where the dielectric layer was not formed. Subsequently, high-frequency characteristics of the wafer were evaluated.

As shown in FIG. 5, the second harmonic characteristics of the wafer for the cases in which the carbon concentrations of the silicon epitaxial films were (1) to (4), were (1) -44.8 dBm, (2) -43.5 dBm, (3) -47.4 dBm, and (4) -52.2 dBm, respectively.

Moreover, the third harmonic characteristics were (1) -60.0 dBm, (2) -61.3 dBm, (3) -63.3 dBm, and (4) - 67.4 dBm.

Based on these results, it was found that both the second harmonic characteristics and the third harmonic characteristics in Comparative Example 1 were inferior to those in Example 1.

As per the results above, it was found that the epitaxial wafer according to the present invention exhibited improved high-frequency characteristics due to an effect of the dielectric layer formed on the silicon epitaxial film doped with carbon.

(Comparative Example 2)

An epitaxial wafer was manufactured in the same way as methods for manufacturing an epitaxial wafer in Example 1 and Comparative Example 1, except that only carbon concentration contained in a silicon epitaxial film doped with carbon was different. First, a silicon epitaxial film doped with carbon (carbon concentration: $3.0 \times 10^{20}$ to $1.0 \times 10^{21}$ atoms/cm$^3$, film thickness: 1 $\mu$m) was formed on a silicon substrate having a diameter of 300 mm (P-type, resistivity of 10 $\Omega \cdot$cm) using monomethylsilane as carbon source gas, in which the silicon substrate was obtained by slicing an ingot produced by a Czochralski method employing a reduced pressure CVD apparatus. Subsequently, an epitaxial wafer, in which a silicon oxide film having a thickness of 400 nm was formed on the silicon epitaxial film doped with carbon, was provided, and an epitaxial wafer without forming a silicon oxide film was provided. These epitaxial wafers were subjected to heat treatment at 1000°C in an oxygen atmosphere under adjusted conditions such that the total heat treatment time was set to 12 hours. These wafers were defined as epitaxial wafers in Comparative Example 2. When the carbon concentration is within this range, it has been found that Void defects are formed when the film thickness is 1 $\mu$m or more.

The carbon concentration of the silicon epitaxial film doped with carbon was set to two values: (1) $3.0 \times 10^{20}$ atoms/cm$^3$, (2) $1.0 \times 10^{21}$ atoms/cm$^3$.

In the same way as in Example 1, second harmonic characteristics and third harmonic characteristics of the epitaxial wafers in Comparative Example 2 were measured, and FIG. 5 shows the results thereof. At this time, as for the epitaxial wafer in which the silicon oxide film had not been formed, an oxide film formed on a surface of the wafer by heat treatment in an oxidizing atmosphere was removed by hydrofluoric acid (hydrofluoric acid), and aluminum electrodes having a line length of 2200 $\mu$m were then formed on the surface where the dielectric layer was not formed to evaluate high-frequency characteristics.

As shown in FIG. 5, when frequency of input signal was set to 1 GHz, the second harmonic characteristics of the epitaxial wafer (with dielectric layer) for the cases, in which the carbon concentrations in the silicon epitaxial film were (1) and (2), were (1) -29.5 dBm and (2) -28.5 dBm, respectively. The second harmonic characteristics (without dielectric layer) were (1) - 26.7 dBm and (2) -26.0 dBm.

Moreover, the third harmonic characteristics (with dielectric layer) were (1) -49.7 dBm and (2) -64.2 dBm, and the third harmonic characteristics (without dielectric layer) were (1) -58.8 dBm and (2) -61.7 dBm.

These results indicate that both the second harmonic characteristics and the third harmonic characteristics in Comparative Example 2 were inferior to those in Example 1.

As described above, according to Example of the present invention, the epitaxial wafer having superior high-frequency characteristics compared with a conventional epitaxial wafer was successfully and easily manufactured without using a high-resistivity substrate, by virtue of effect of the silicon epitaxial film containing the minute carbon defects at high density and the dielectric layer.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. An epitaxial wafer comprising, in this order, a silicon epitaxial film having a carbon concentration of $2\times10^{19}$ atoms/cm$^3$ or more and less than $3\times10^{20}$ atoms/cm$^3$ and containing carbon defects and a dielectric layer on a silicon single crystal substrate having a resistivity of 10 $\Omega$·cm or more and 5000 $\Omega$·cm or less, wherein

   a thickness of the silicon epitaxial film satisfies $6.6 \times 10^{20} \times \exp\{-1.6 \times$ [the thickness of the epitaxial film ($\mu$m)]$\} >$ [the carbon concentration of the epitaxial film (atoms/cm$^3$)].

2. The epitaxial wafer according to claim 1, wherein
   the epitaxial wafer is a wafer for a high-frequency device.

3. The epitaxial wafer according to claim 1 or 2, wherein
   the carbon defects have a size of 10 nm or less, and a density of $1\times10^{10}$ cm$^{-2}$ or more in the epitaxial film.

4. A method for manufacturing an epitaxial wafer, the method comprising the steps of:

   providing a silicon single crystal substrate having a resistivity of 10 $\Omega$·cm or more and 5000 $\Omega$·cm or less;
   vapor-phase growing a silicon epitaxial film doped with carbon having a carbon concentration of $2\times10^{19}$ atoms/cm$^3$ or more and less than $3\times10^{20}$ atoms/cm$^3$ on the silicon single crystal substrate, under reduced pressure;
   forming a dielectric layer on the silicon epitaxial film; and
   forming carbon defects in the silicon epitaxial film by subjecting the silicon single crystal substrate on which the dielectric layer has been formed to heat treatment at a heat treatment temperature of 900°C or more and 1100°C or less for a heat treatment time of 3 hours or more and 36 hours or less, wherein
   the silicon epitaxial film is formed in the step of vapor-phase growing a silicon epitaxial film, in which the silicon epitaxial film has a thickness that satisfies $6.6 \times 10^{20} \times \exp\{-1.6 \times$ [the thickness of the epitaxial film ($\mu$m)]$\} >$ [the carbon concentration of the epitaxial film (atoms/cm$^3$)].

5. The method for manufacturing an epitaxial wafer, wherein
   the epitaxial wafer manufactured by the method for manufacturing an epitaxial wafer according to claim 4 is employed as a wafer for a high-frequency device.

6. The method for manufacturing an epitaxial wafer according to claim 4 or 5, wherein
   the carbon defects have a size of 10 nm or less, and a density of $1\times10^{10}$ cm$^{-2}$ or more in the epitaxial film.

[FIG. 1]

1

4

3

2

[FIG. 2]

Silicon Substrate

Forming Silicon Epitaxial Film doped with Carbon

Silicon Epitaxial Film doped with Carbon
Silicon Substrate

Forming Oxide Film

Dielectric Layer
Silicon Epitaxial Film doped with Carbon
Silicon Substrate

Heat Treatment

Dielectric Layer
Epitaxial Film doped with Carbon with Formed Minute Carbon Defects at High Density
Silicon Substrate

[FIG. 3]

Thickness of Silicon Epitaxial Film /μm

[FIG. 4]

[FIG. 5]

## INTERNATIONAL SEARCH REPORT

| International application No. |
|---|
| **PCT/JP2024/028001** |

### A. CLASSIFICATION OF SUBJECT MATTER

*C30B 29/06*(2006.01)i; *C30B 25/20*(2006.01)i; *C30B 33/02*(2006.01)i; *H01L 21/02*(2006.01)i; *H01L 21/20*(2006.01)i; *H01L 21/205*(2006.01)i; *H01L 21/316*(2006.01)i; *H01L 21/322*(2006.01)i; *H01L 27/12*(2006.01)i

FI:    C30B29/06 504A; H01L21/205; H01L21/322 G; H01L21/20; H01L27/12 B; C30B25/20; C30B33/02; H01L21/316 S

According to International Patent Classification (IPC) or to both national classification and IPC

### B. FIELDS SEARCHED

Minimum documentation searched (classification system followed by classification symbols)

    C30B29/06; C30B25/20; C30B33/02; H01L21/02; H01L21/20; H01L21/205; H01L21/316; H01L21/322; H01L27/12

Documentation searched other than minimum documentation to the extent that such documents are included in the fields searched

    Published examined utility model applications of Japan 1922-1996
    Published unexamined utility model applications of Japan 1971-2024
    Registered utility model specifications of Japan 1996-2024
    Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2023-54965 A (SHIN-ETSU HANDOTAI CO., LTD.) 17 April 2023 (2023-04-17) paragraphs [0030]-[0079] | 1, 2 |
| Y | | 3 |
| A | | 4-6 |
| Y | JP 2009-212353 A (SUMCO CORP.) 17 September 2009 (2009-09-17) paragraphs [0012]-[0089] | 3 |
| A | US 2018/0337043 A1 (PSEMI CORPORATION) 22 November 2018 (2018-11-22) paragraphs [0069]-[0149] | 1-6 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **25 September 2024** | **08 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/028001**

| Patent document cited in search report | | | Publication date (day/month/year) | Patent family member(s) | | | Publication date (day/month/year) |
|---|---|---|---|---|---|---|---|
| JP | 2023-54965 | A | 17 April 2023 | (Family: none) | | | |
| JP | 2009-212353 | A | 17 September 2009 | US | 2009/0226737 | A1 | |
| | | | | paragraphs [0033]-[0161] | | | |
| | | | | KR | 10-2009-0095494 | A | |
| | | | | TW | 201001554 | A | |
| US | 2018/0337043 | A1 | 22 November 2018 | WO | 2018/212976 | A1 | |
| | | | | CN | 110637369 | A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015503853 A
- JP 2019129195 A
- JP 2009164590 A
- JP 2009200231 A
- JP 2006216934 A